# EUROPEAN PATENT SPECIFICATION

(11) **EP 2 826 565 B1**
(45) Date of publication and mention of the grant of the patent: **20.11.2019**
(21) Application number: 13176587.7
(22) Date of filing: 16.07.2013
(51) Int. Cl.: B03C 3/017, B03C 5/02, H05K 7/20

(54) **An electronic and/or electrical module arrangement for a subsea installation**
Elektronische und/oder elektrische Modulanordnung für eine Unterwasserinstallation
Ensemble électronique et/ou de module électrique pour une installation sous-marine

(43) Date of publication of application: 21.01.2015
(73) Proprietor: ABB Schweiz AG, 5400 Baden (CH)
(72) Inventor: Spindler, Christian, CH-8707 Uetikon am See (CH); Grinberg, Roman, CH-8051 Zurich (CH)
(74) Representative: Kransell & Wennborg KB

(56) References cited:
- EP-A1- 2 487 327
- EP-A1- 2 579 438
- US-A- 4 285 805
- US-A- 4 402 818
- US-A- 4 961 845
- US-A- 5 149 422
- US-A- 5 954 933
- US-A- 6 129 829
- US-A1- 2013 056 180

## Description

### TECHNICAL FIELD.

The present invention is concerned with a filter system for an electronic and/or electrical module arrangement electronic and/or electrical equipment used in a subsea installation, which said module arrangement includes an electronic and/or electrical module arrangement is arranged inside an enclosure and immersed in a dielectric liquid. In particular it is concerned with an electrostatic particle filter which is arranged in contact with the liquid in the enclosure and configured for the purpose of removing contaminants from the liquid. The subsea installation comprises one or more systems of electrical power distribution installed subsea for supplying a plurality of electrical loads used in applications and equipment for oil and gas extraction, production, processing or transportation.

### TECHNICAL BACKGROUND

Distribution of electrical power to electronic and/or electrical equipment in subsea installations is currently under development. In subsea applications, the ambient hydrostatic pressure increases by 1 bar each 10 m of water depth. Two basic technological concepts foresee either the installation of a thick and rigid container, keeping the interior pressure at 1 bar in order to protect sensitive electronics. Such large, heavy and rigid enclosures present difficulties both for shipping to site and in installing on the seabed. Deliveries to platforms and oil fields out to sea are usually made using e.g. oil field support ships which have limited deck space and cargo handling equipment. Large and heavy enclosures also are awkward and difficult to handle when installing equipment on the seabed using remotely operated vehicles (ROVs), for example to maneuver, position and connect different sections of equipment to one another in a system.

A preferable alternative for an enclosure is a thin-walled container being filled with an insulating, incompressible liquid which automatically takes on the ambient pressure of the surrounding hydrostatic pressure and which requires some adaption of sensitive parts inside the container. The passive pressure compensated concept has various advantages and represents the base case of current developments. Insulating liquid also acts as a cooling medium for the power electronics components.

One of the challenges to be solved for electrical and electronic equipment enclosed in a container and immersed in an insulating oil or dielectric liquid is degradation of the quality of the insulating liquid due to contamination. The quality of the insulating liquid can be ensured at the time of commissioning. However, during operation and over time, the liquid quality will degrade. The reasons for contamination of potential insulating liquids (for example various types of oil) for the pressure compensated application are many. Most often it can be expected that oxidation that occurs in the oil leads over time to formation of insoluble substances, which in turn leads to sludge formation. Oxygen sources in the subsea vessel are, for example, degrading polymers. Another reason for contamination could be diffusion of solid materials used in the electrical equipment, for example in a frequency converter, into the oil. Examples are again degrading polymers, delaminated coatings, gel or rubberlike materials, or debris from partial discharges.

The intensity of oxidation and the diffusion process may be accelerated by temperature cycling. One additional reason for oil contamination could be arcing. Arcing that could result from electrical design errors or insufficient insulation distances and would lead to formation of carbon particles in the oil. Overall, presence of contamination in the oil will lead to reduction of its breakdown strength. Moreover, particles often tend to settle or accumulate on live parts in the system due to a polarization effect.

As a result, cooling will be reduced which could lead to higher component temperatures and intensify their aging. To maintain the acceptable quality of the oil and reduce its effect on converter lifetime, measures must be taken. The most common way of contamination reduction in oil under operation in general industrial applications is employment of mechanical filters based on porous materials. An example would be an engine oil filter as generally used in cars. Engine oil is usually pumped around an engine and passed through an oil filter. The general problem with mechanical filters is the limit on the size of contaminants. Since the majority of contaminants in the oil are of submicron size, they cannot be removed by a mechanical filter. Filtering such small size particles would require an extremely fine filter, which in turn would highly negatively affect the cooling performance and would also be prone to fast clogging.

Another approach is the use of electrostatic technology or electrostatic precipitation to treat an oil. An abstract from JPS62176559, entitled: Electrostatic Precipitation Type Oil Filter Apparatus; and assigned to Tsuchiya Mfg Co Ltd, from the technical field of oil filters for combustion engines, describes in one embodiment that due to an electric field between DC electrodes 13a and 13b carbon particles in the flowing oil are charged and accumulated on the same electrodes or on adjacent filter paper 22. Oil flows in via an inlet 19 at the bottom of the apparatus and out from an outlet 27 at the top.

An abstract from MD20040256, entitled: Electrostatic precipitator for liquids, and assigned to Institute Fizica Aplicata Stiinte (MD) describes purification of dielectric liquids from mechanical impurities, namely of transformer, vegetable, machine oils, [...] from different insoluble inclusions and may be used in power engineering mechanical engineering, radio electronics, petrochemical engineering, food industry. An electrostatic precipitator is described with a high voltage cylindrical electrode 4 and coaxially placed annular electrodes 5 separated by dielectric rings 6. The electrostatic precipitator comprises a grounded body 1. The oil flow is presumably pressurized, as the diagram shows a liquid inlet 2 in the bottom of the container and a liquid outlet 3 at the top. The abstract of CN86104995, entitled: Method For Purification Of Insulating Oil By High Gradient And Stable Electrostatic Field, and assigned to Aansham Electrostatic Technological Institute (CN) describes a technique of insulating oil purification. A relatively strong uniform electrical field is formed between the grounding and high voltage terminals by using very fine textile fibres with dielectric properties, such as polyamide, polyester or glass. In the high gradient and stable electrostatic field [...] micro-drops of water and micro-particles are effectively collected and trapped. The purification of transformer oil (claimed by this method in one run only), can increase the insulating intensity of the oil from 12 KV/2.5 MM to 63 KV/2.5 MM. The oil flow is presumably pressurized, as the diagram of the second abstract also shows that oil enters the lower part of the precipitator through an inlet 5 and exits at the top of the precipitator through an outlet 4.

US 2013/056180 discloses an energy conversion device that includes a power module, elements for cooling the power module, and a sealed enclosure for housing the power module and at least one portion of the cooling elements. The cooling elements include a cooling circuit, in which a heat transfer fluid circulates, a first heat exchange with the power module, through which passes the heat transfer fluid of the cooling circuit and at least one pump for driving the heat transfer fluid circulating in the circuit. The enclosure includes an area for receiving heat transfer fluid, filled with heat transfer fluid, and the cooling circuit includes an inlet orifice in the circuit made upstream from the driving pump and opening into the heat transfer fluid of the receiving area.

EP 2 579 438 discloses a power cell for deepwater application and comprises an power cell housing, a capacitor bank, an electronic module, and input/output connectors, wherein the power cell housing is essentially made of an insulating material. It furthermore discloses a power cell system comprising a number of replaceable power cells, a frame for supporting the power cells, and electric connections, in particular a busbar arrangement for connecting to the power cell.

However despite the teachings of the above documents improvement in reducing contaminants in dielectric liquids surrounding an electronic and/or electrical equipment used in a subsea installation is still required.

### SUMMARY OF THE INVENTION

The aim of the present invention is to remedy one or more of the above technical challenges. This and other aims are obtained by a device characterised by claim 1.

In a first aspect of the invention, an electronic and/or electrical module arrangement for a subsea installation is disclosed, which said module arrangement is powered by an AC or DC link power supply and comprises an electronic and/or electrical equipment which is arranged in an enclosure and immersed in a dielectric liquid, wherein an electrostatic particle filter is arranged in contact with the dielectric liquid inside the enclosure and configured for removing contaminants from the dielectric liquid.

The electronic and/or electrical module arrangement of the first aspect of the present invention addresses the challenge of removing contaminants and in particular particulate matter from the dielectric liquid contained in the enclosure of the module arrangement. Particles in the dielectric fluid are attracted to the electrostatically charged plates of the electrostatic filter by the high voltage electric field. The particles remain held to the electrostatic plates by electrostatic attraction and/or polarization. In preference to a mechanical filter, the electrostatic filter is less prone to clogging, and is not prevented from separating out particle of extremely small (sub-micron) size by limitations of filter a pore size or mesh. Thus small particles of a size measured in fractions of microns may be separated from the liquid before they have had time to agglomerate into larger particles.

An advantage of the present invention is that an electrostatic filter normally requires a medium-high voltage DC power supply, and a medium-high DC voltage is readily available from certain electrical or electronic equipment, for example frequency converters. In the embodiment the electrostatic filter is powered directly from the DC link of a subsea converter. For a voltage-source converter with, say, an input of 6kV, the DC link voltage is around 10kV. This is in the range of values of around 10-15kV DC used in off-line oil electrostatic filters of the type used in oil separation and oil filtration products for industrial applications on land. Therefore a dedicated power supply for the electrostatic filter is not required, resulting in a significant space saving, leading to a saving in size and thus weight of the enclosure; a cost saving; and an improved reliability without the additional power supply component. Generally then no extra power supply circuitry for the electrostatic filter is required (except, possibly for a filtering circuit).

In a subsea application it is very advantageous to provide filtration without depending on a pump or other actuator means to create a cooling flow such as a circulation of the dielectric liquid, as the risk of pump or motor failure in a subsea installation is substantially unacceptable. Maintenance operations and repairs on the seabed are technically extremely difficult, as well as prohibitively expensive, and so the elimination of potential equipment failures is paramount.

A reduction in size and weight is also to be gained when no pump or other actuator is required in order to pressurize the dielectric fluid to move it past the filter apparatus - the electrostatically charged plates. A smaller size for an enclosure is an advantage when applied in a subsea installation. A reduced equipment size and weight means that the resulting size and weight of each seawater proof enclosure is more easily handled. The equipment is more easily handled for shipping out to an oil production site at sea and also for installation, connection etc., on site.

The use of electrostatic particle precipitation at around the same voltage as the highest voltage of electric or electronic equipment in the enclosure means that contamination particles that would otherwise be attracted towards, and subsequently settle on, live elements in the system are continually urged by the applied electric field to move towards the charged plates of the electrostatic precipitator or electrostatic particle filter. Thus contamination that would lead to deterioration in breakdown strength is reduced as well as avoiding a coating of electrical equipment leading in turn to increased thermal heating of the electrical or electronic equipment. Contamination in the dielectric liquid may be removed very effectively with the electrostatic particle filter disclosed, providing a longer service life of the dielectric liquid in subsea equipment. Another advantage of the filter system is that the utilization of electrostatic technology in the pressure compensated concept would allow the filtration of sub-micron size particles and prevent the contamination of the insulating liquid. As a result, subsea system lifetime will be additionally increased and a longer maintenance interval may also be expected.

According to an embodiment, an electronic and/or electrical module arrangement for a subsea installation is disclosed, and which said module arrangement is powered by an AC or DC link power supply and comprises an electronic and/or electrical equipment arranged in an enclosure and immersed in a dielectric liquid, and where an electrostatic particle filter is arranged in contact with the dielectric liquid,
wherein said electronic and/or electrical equipment comprises at least one equipment from the group of: a variable frequency converter, a transformer, a switchgear, an electrical distribution box or junction. The invention may advantageously be constructed or combined with many different types of electrical and/or electronic equipment for providing power distribution and power supply to electrical equipment such as pumps, actuators and compressors installed subsea.

According to another embodiment, an electronic and/or electrical module arrangement for a subsea installation is disclosed, and which said module arrangement is powered by an AC or DC link power supply and comprises an electronic and/or electrical equipment arranged in an enclosure and immersed in a dielectric liquid, and where an electrostatic particle filter is arranged in contact with the dielectric liquid, and wherein said electronic and/or electrical equipment comprises one or more capacitors.
According to an embodiment, an electronic and/or electrical module arrangement for a subsea installation is disclosed, and which said module arrangement is powered by an AC or DC link power supply and comprises an electronic and/or electrical equipment arranged in an enclosure and immersed in a dielectric liquid, and where an electrostatic particle filter is arranged in contact with the dielectric liquid, and wherein the electrostatic particle filter is supplied with electrical power by a DC power supply connected to said electronic and/or electrical equipment. As noted above in many equipment installations a medium-to-high voltage DC source is already available to power a variable frequency converter, for example, and thus no separate or dedicated power supply equipment or power bus is necessary for the electrostatic particle filter, thus saving space in the subsea enclosure and thereby a saving in weight of the enclosure as well.

According to an example not forming part of the invention, an electronic and/or electrical module arrangement for a subsea installation is disclosed, and which said module arrangement is powered by an AC or DC link power supply and comprises an electronic and/or electrical equipment arranged in an enclosure and immersed in a dielectric liquid, and where an electrostatic particle filter is arranged in contact with the dielectric liquid, and wherein the electrostatic particle filter is powered from an AC input supply to said electronic and/or electrical equipment. In the case where no medium to high voltage DC supply is arranged but a medium-to-high voltage AC supply is available, then the electrostatic particle filter requires a limited power supply adaption of rectifier or similar to convert from AC to DC.

According to an embodiment, an electronic and/or electrical module arrangement for a subsea installation is disclosed, which said module arrangement is powered by an AC or DC link power supply and comprises electrical and/or electronic equipment immersed in a dielectric liquid, and where an electrostatic particle filter is arranged in contact with the dielectric liquid and wherein the dielectric liquid is an insulating oil or ester. The electrostatic particle filter may also remove contaminants from the dielectric liquid while they are of a very small, sub-micron size, thus reducing deterioration in breakdown strength of the liquid.

According to an embodiment, an electronic and/or electrical module arrangement for a subsea installation is disclosed, and which said module arrangement is powered by an AC or DC link power supply and comprises an electronic and/or electrical equipment arranged in an enclosure and immersed in a dielectric liquid, and where an electrostatic particle filter is arranged in contact with the dielectric liquid, and wherein the electrostatic particle filter is arranged inside the enclosure in a position such that the dielectric liquid is urged to flow past the electrostatic particle filter by means of natural convection currents caused by thermal losses in said electronic and/or electrical equipment. Contaminants are attracted from the liquid to the charged plates during the continuous slowly moving flow of dielectric liquid past the electrostatically charged filter plates.

According to an embodiment, an electronic and/or electrical module arrangement for a subsea installation is disclosed, and which said module arrangement is powered by an AC or DC link power supply and comprises an electronic and/or electrical equipment arranged in an enclosure and immersed in a dielectric liquid, and where an electrostatic particle filter is arranged in contact with the dielectric liquid, and wherein the electrostatic particle filter is arranged in a second position inside a container connected to the enclosure. According to an embodiment the electrostatic particle filter may be arranged close to a side of the enclosure and according to another embodiment the electrostatic particle filter may be arranged in a chamber or container connected to and communicating with the enclosure. Placement of at least part of the filter apparatus in a chamber or container facilitates cleaning or exchange of at least part of the filter.

According to another embodiment, an electronic and/or electrical module arrangement for a subsea installation is disclosed, and which said module arrangement is powered by an AC or DC link power supply and comprises an electronic and/or electrical equipment arranged in an enclosure and immersed in a dielectric liquid, and where an electrostatic particle filter is arranged in contact with the dielectric liquid, and wherein a flow of the dielectric liquid is urged in part by a pump.
A flow may advantageously be urged by an actuator or pump, in particular when the electrostatic particle filter is arranged in a container or chamber connected to and communicating with the enclosure. As noted above placement of at least part of the filter apparatus in a chamber or container facilitates cleaning or exchange of at least part of the filter.

According to an embodiment, an electronic and/or electrical module arrangement for a subsea installation is disclosed, and which said module arrangement is powered by an AC or DC link power supply and comprises an electronic and/or electrical equipment arranged in an enclosure and immersed in a dielectric liquid, and where an electrostatic particle filter is arranged in contact with the dielectric liquid, and wherein the enclosure, or a container connected to it, is arranged comprising one or more sensors. By this means the efficiency or effectiveness of the electrostatic filter may be monitored to detect any reduction in filter separation efficiency or reduction in parameters related to breakdown strength of the dielectric liquid.

According to another embodiment, an electronic and/or electrical module arrangement for a subsea installation is disclosed, and which said module arrangement is powered by an AC or DC link power supply and comprises an electronic and/or electrical equipment arranged in an enclosure and immersed in a dielectric liquid, and where an electrostatic particle filter is arranged in contact with the dielectric liquid, and wherein said electronic and/or electrical equipment in said module arrangement is used to control and/or drive one or more subsea loads from any of the group of: a motor, an induction motor, a pump, a water injection pump, a compressor, a gas compressor, a multiphase pump motor, a separator pump motor.

According to a second aspect of the invention which is defined by claim 10, a method for operating an electronic and/or electrical module arrangement for a subsea installation is disclosed, which said module arrangement is powered by an AC or DC link power supply and comprises electronic and/or electrical equipment which is arranged in an enclosure and immersed in a dielectric liquid, wherein an electrostatic particle filter is arranged in contact with the dielectric liquid inside the enclosure and configured for removing contaminants from the liquid, wherein the electrostatic particle filter is supplied with electrical power by a DC power supply to said electronic and/or electrical equipment, and by the method steps of:
switching on the AC or DC power supply and monitoring said electronic and/or electrical equipment with one or more sensors, and if a signal is detected that a parameter related to a condition of the electrostatic particle filter is measured or estimated to be greater than a predetermined threshold, then signaling a requirement for exchange, or cleaning, of the electrostatic particle filter.

The second aspect of the invention, a method of operation of an electronic and/or electrical module arrangement with an enclosure comprising an electrostatic particle filter discloses receiving sensor information that indicates when an electrostatic particle filter is no longer working effectively. This is a great advantage as it means that timely measures may be taken, for example by reducing service load, by switching service load to other equipment and so on while measures are planned or carried out to clean or replace the electrostatic filter or parts of the filter.

According to an embodiment, a method for operating an electronic and/or electrical module arrangement for a subsea installation is disclosed, which said module arrangement is powered by an AC or DC link power supply and comprises electronic and/or electrical equipment which is arranged in an enclosure and immersed in a dielectric liquid, and where an electrostatic particle filter is arranged in contact with the dielectric liquid, and wherein a requirement for exchange, or cleaning, of the electrostatic particle filter has been signaled, by the steps of carrying out a procedure for cleaning the electrostatic particle filter using any method from the group of:
applying one or more electrical pulses of a selected polarity across the filter; applying one or more mechanical vibrations to the electrostatic particle filter; a combination of mechanical and electrostatic methods.

According to an embodiment, a method for operating an electronic and/or electrical module arrangement for a subsea installation is disclosed, which said module arrangement is powered by an AC or DC link power supply and comprises electronic and/or electrical equipment which is arranged in an enclosure and immersed in a dielectric liquid, and where an electrostatic particle filter is arranged in contact with the dielectric liquid, and wherein a requirement for exchange, or cleaning, of the electrostatic particle filter has been signaled,
by the steps of exchanging a first container connected to the enclosure comprising the electrostatic particle filter and replacing it with a second container comprising a second and clean electrostatic particle filter.

According to a third aspect of the invention a computer readable medium as defined in claim 14 is disclosed which has recorded on it a computer program for operating an electronic and/or electrical module arrangement for a subsea installation, which said module arrangement is powered by an AC or DC link power supply and comprises electronic and/or electrical equipment which is arranged in an enclosure and immersed in a dielectric liquid, and where an electrostatic particle filter is arranged in contact with the dielectric liquid inside the enclosure and configured for removing contaminants from the liquid, according to the first aspect of the invention. The computer readable medium, or data carrier, has computer program code recorded on it which, when run on a processor, a controller, a control unit or control and protection unit, causes the processor/controller to perform a method according to the second aspect of the invention.

Furthermore, a system for subsea power distribution is disclosed, which system comprises at least one electronic and/or electrical module arrangement for a subsea installation, which said module arrangement is powered by an AC or DC link power supply and comprises electronic and/or electrical equipment which is arranged in an enclosure and immersed in a dielectric liquid, and where an electrostatic particle filter is arranged in contact with the dielectric liquid inside the enclosure and configured for removing contaminants from the dielectric liquid.

It is to be noted that any feature of the first aspect may be applied to the second aspect and the third aspect, wherever appropriate. Likewise, any advantage of the first aspect may equally apply to the second aspect, and/or the third aspect, respectively, and vice versa. Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated. The use of "first", "second" etc. for different features/components of the present disclosure are only intended to distinguish the features/components from other similar features/components and not to impart any order or hierarchy to the features/components.

### BRIEF DESCRIPTION OF THE DRAWINGS

A more complete understanding of the method and system of the present invention may be had by reference to the following detailed description when taken in conjunction with the accompanying drawings wherein:
Figure 1 shows a block diagram of electronic and/or electrical module arrangement including an enclosure comprising electronic and/or electrical equipment immersed in a dielectric liquid and further comprising an electrostatic particle filter for use subsea according to a first aspect of the invention;
Figure 2 is a schematic flowchart illustrating methods for operating the invention of Figure 1 according to a second aspect of the invention; Figures 3-4, are also schematic flowcharts of methods for operating the invention of Figure 1 and in particular in Figure 3 for exchanging the electrostatic particle filter when full, and respectively in Figure 4 for cleaning the electrostatic particle filter when full or otherwise necessary;
Figure 5 shows a subsea power distribution system comprising the invention of Figure 1 according to a third aspect of the invention;
Figure 6 schematically shows a computer program product comprising computer readable code according to a fourth aspect of the invention;
Figures 7a, 7b, 7c are block diagrams for parts of different embodiments of the invention of Figure 1 and showing in particular alternative positions for the electrostatic filter in relation to the enclosure.

### DESCRIPTION OF THE PREFERRED EMBODIMENTS

The present invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention which is defined by the appended claims.

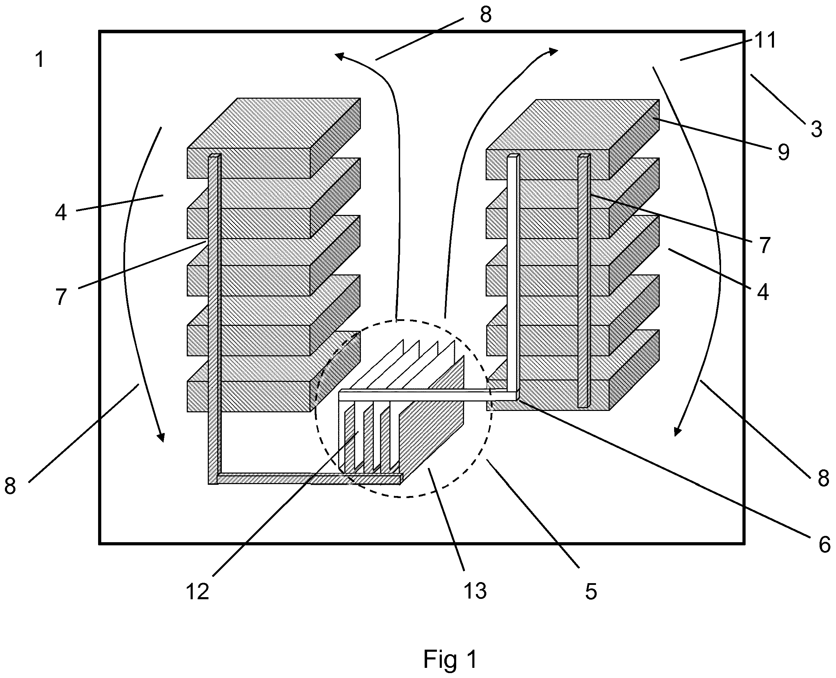

Figure 1 shows an embodiment according to the first aspect of the invention. Figure 1 shows an electronic and/or electrical equipment module arrangement 1, including electronic and/or electrical equipment 4 arranged inside an enclosure 3 and immersed in a dielectric liquid 11. The enclosure 3 is preferably of the pressurised type, including a type of pressure compensation. The figure shows in particular a plurality of semiconductor devices 9, such as power electronics building blocks (PEBBs), making up a frequency converter device. A frequency converter is described here in some detail as an exemplary example of an electronic and/or electrical equipment to illustrate the workings of the present invention. The invention is not at all limited to applications comprising a frequency converter as shall be further described in some detail.

The electronic and or electrical equipment 1 comprises then in this example a plurality of semiconductor components 9 which generate heat due to electrical losses when the frequency converter device 4 is operated. Under the effect of increased operating temperature and over time and during accumulation of pollutants, the quality of the liquid 11 changes over time. Liquid 11 is a dielectric liquid, such as an insulating oil or liquid ester. As previously mentioned in the Technical Background, the reasons for contamination of insulating liquids (for example various types of oil) are many. Most often it can be expected that oxidation that occurs in the oil over the passage of time leads to formation of insoluble substances, which lead to sludge formation. In addition, any arcing that may result from electrical design errors or insufficient insulation distances will lead to formation of carbon particles in the oil. Overall, presence of contamination in the oil will lead to reduction of its breakdown strength. Moreover, contaminants in particle form tend to accumulate on live parts in an electrical system due to the polarization effect. During operations over a long time then contamination of the dielectric liquid 11 takes place which may also include a build-up of insoluble particles, sludge particles or carbon particles particularly on live parts of the equipment.

Figure 1 also shows two sets of bus bars, 6 and 7. The busbars 6 and 7 are used to deliver power to the power semiconductor components 9 of the electrical and/or electronic equipment 4. Bus bar 6 may have a positive DC+ polarity and busbar 7 may have a negative DC- polarity. An electrostatic particle filter 5, indicated by a circular shape 13 is also connected to busbars 6, 7. The electrostatic particle filter 5, which is also immersed in the liquid 11, comprises one first set of plate elements 12 connected to busbars 6 of a first polarity (e.g. DC+) and a second set of plate elements 13 which are connected to busbar 7 with a second polarity (e.g. DC-). Figure 1 also shows a flow of convection currents 8 in the liquid 11 due to the natural convection cooling process whereby warm fluid rises towards the top in enclosure 3 and as the liquid cools it falls towards the bottom of the enclosure 3.

Advantageously the electrostatic filter can work on-line, during normal operation of the electronic and/or electrical equipment 1, so the electrode elements 12, 13 are positioned in the liquid flow created by natural convection flows 8 as shown in Figure 1. The electrostatic particle filter 5 in Figure 1 is shown placed in a first position quite central and substantially lower in the enclosure than the position of the power electronic components 4. No pump is necessary to force the liquid flow through the filter. Other positions of the filter in the oil flow (for example, on the sides of the tank) as well as, or instead of a filter in the bottom part of the enclosure, may also be considered.

A second feature of the present embodiment, as shown in Figure 1, is that the electrostatic particle filter is powered directly from a DC power supply of a subsea converter, see busbars 6, 7 in Figure 1. For example, with a voltage-source converter having, say, a 6kV input, the DC link voltage may be around 10kV. This is in the range of values used in off-line oil electrostatic filters used in general industrial applications on land as mentioned above in the Summary section of this description. Therefore, no extra power supply circuitry is required (except, possibly a filtering circuit) in order to power the electrostatic filter which results the cost/space savings and improved reliability.

The external housing 3 is made of a material which has high thermal conductivity, preferably a metal such as steel e.g. stainless steel. The dielectric liquid 11 fills the entire interior space of the enclosure 3 so as to prevent the occurrence of any air gaps between the internal surface of the external housing 3 and any internal component, such as an electric or electronic device 4, contained in the enclosure 3.

The dielectric liquid 11 counteracts deformation of the enclosure when enclosure 3 is subjected to an ambient external subsea pressure higher than a pressure that the enclosure 3 can withstand without deformation. The passive pressure compensation is arranged to transmit ambient subsea pressure to the inside of the enclosure 3. Thereby a pressure difference between ambient subsea pressure and pressure inside the enclosure 3 may be reduced. The passive pressure compensation may for example be defined by a mechanically flexible portion of the external housing 3 (not shown), or a membrane such as an impermeable membrane. (not shown) The interior volume of the enclosure 3 and thus the pressure inside the housing hence dependent of the ambient subsea pressure.

The dielectric liquid 11 may for example be an oil or an ester, and prevents short circuit of any electronic or electric device contained in the enclosure 3. Examples of electronic devices which may be housed in enclosure 3 are capacitors, for example capacitors based on metalized film technology or on oil-soaked film-foil technology, and power electronic devices such as insulated gate bipolar transistor (IGBT) modules, integrated gate-commutated thyristors (IGCT), diodes, and thyristors, while examples of electric devices are frequency converters and transformers, which in the former case include capacitors and power electronic devices such as IGBT modules.

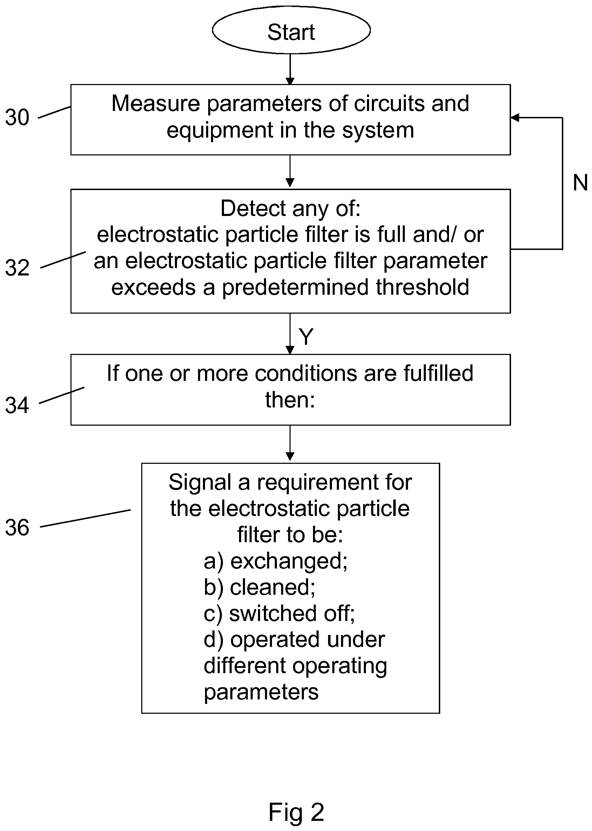

Figure 2 shows a flowchart for a method according to a second aspect of the invention. The method includes one or more of the following steps:
30 Measure parameters of circuits and equipment in the system,
32 Detect any of: electrostatic particle filter is full and/or an electrostatic particle filter parameter exceeds a predetermined threshold,
34 if Yes and one or more conditions are fulfilled, then
36 Signal a requirement for the electrostatic particle filter to be: a) exchanged; b) cleaned; c) switched off; d) operated under different or other predetermined operating conditions.

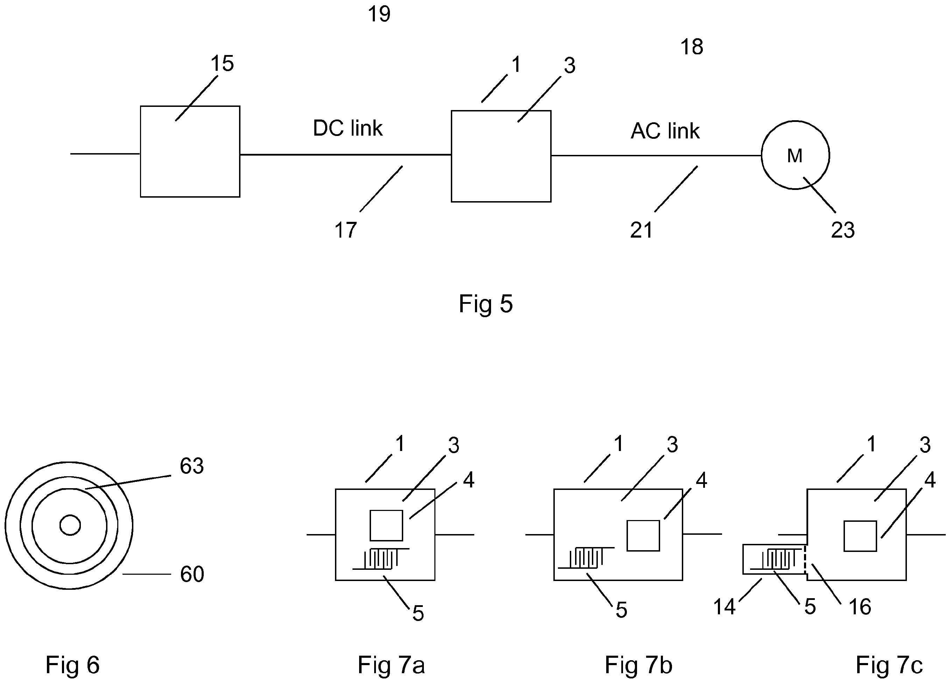

Thus when the electrostatic particle filter 5 is detected to be "full" or partly loaded with contaminants such that parameter measurements exceed a predetermined threshold, then this information is made available such that action may be taken to remedy the situation. The apparatus in the enclosure 3 may be operated at a lower or different (d) power rate or level while the module arrangement condition is assessed. The electrostatic filter in enclosure 3 may be cleaned (b), either on-line or while in a switched-off condition. The filter may be exchanged (a) for a new or otherwise clean filter. Preferably exchange is facilitated according an embodiment of the module arrangement, which has an enclosure constructed with a container (see e.g. nr. 14, Fig 7c) connected to and communicating (see e.g. nr. 16, Fig 7c) with the enclosure containing the electrostatic filter.

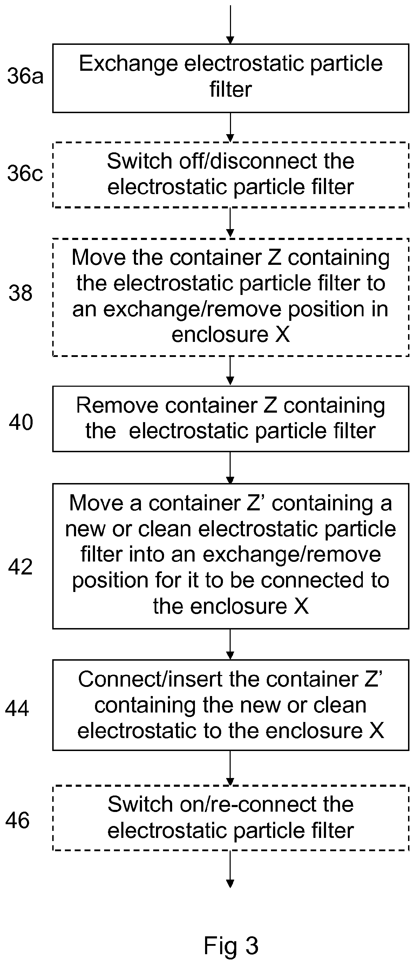

Figure 3 shows a flowchart for a method according to the second aspect of the invention and in particular for exchanging a filter. The method includes one or more of the following steps:
36a Exchange electrostatic particle filter;
36c Switch off/disconnect the electrostatic particle filter
38 Move the container containing the electrostatic particle filter to an exchange/remove position in or relative to enclosure 3;
40 Remove container containing the electrostatic particle filter;
42 Move a second container containing a new or otherwise clean electrostatic particle filter into an exchange/remove position for it to be connected to the enclosure 3;
44 Connect/insert the new container containing the new or clean electrostatic to the enclosure 3;
46 Switch on/re-connect the electrostatic particle filter.

Method steps 36c and 46 are in a box drawn with a dashed line to indicate that one or more parts of these steps are optional or may be carried out offline. For example all equipment in enclosure 3 may be switched off/disconnected such that a separate disconnection/connection for the electrostatic particle filter to carry out an exchange may be unnecessary. Step 54 may also be an optional method step. The steps of any method disclosed herein do not have to be performed in the exact order disclosed, unless explicitly stated.

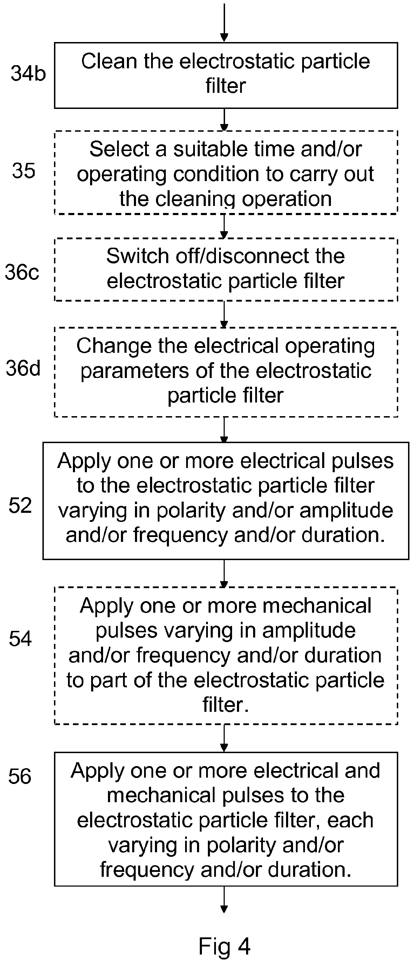

Figure 4 shows a flowchart for a method according to the second aspect of the invention and in particular for cleaning a filter. The method includes one or more of the following steps:
34b Clean the electrostatic particle filter
35 Select a suitable time and/or operating condition to carry out the cleaning operation
36c Switch off/disconnect the electrostatic particle filter
36d Change the electrical operating parameters of the electrostatic particle filter
52 Apply one or more electrical pulses to the electrostatic particle filter varying in polarity and/or amplitude and/or frequency and/or duration.
54 Apply one or more mechanical pulses varying in amplitude and/or frequency and/or duration to part of the electrostatic particle filter.
56 Apply one or more electrical and mechanical pulses to the electrostatic particle filter, each varying in polarity and/or frequency and/or duration.

Steps 35-36d are in a box drawn with a dashed line to indicate that one or more parts of these steps are optional or may be carried out offline. Step 54 may also be an optional method step.

Figure 5 is a schematic block diagram for a system for subsea power distribution comprising at least one electronic and/or electrical module arrangement of the first aspect of the present invention. The diagram shows a system 19 for subsea power distribution, a power supply 15, a subsea DC link 17, an electronic and/or electrical module arrangement 1 comprising an enclosure 3 (not shown in detail), an AC subsea link 21 and a motor M 23. Power supply 15 may be a grid supply from land or topside e.g. an oil platform ship or other vessel, or onshore rectifier connected for supplying DC current to a one or more subsea loads M through a long cable 17.

In a first electronic and/or electrical module arrangement 1 an enclosure 3 (shown in Figure 1) is shown arranged comprising, in this exemplary example of a system, a variable frequency converter arranged as a DC/AC rectifier. An AC supply is fed from the rectifier arrangement in electronic and/or electrical module arrangement 1 through an AC subsea cable link 21 to a load such as a motor M 23. The motor load may for example be to power a pump or a compressor. A plurality of electronic and/or electrical module arrangements 18 may be arranged comprised in one power distribution system 19. Different electronic and electrical equipment may be arranged in the plurality of electronic and/or electrical module arrangements comprising any of DC/AC converters, AC/DC rectifiers, AC/AC converters, voltage source converter, current source converter, transformers, capacitors, a bypass switch, a switchgear and so on.

Figures 7a-c show different embodiments in which the electrostatic particle filter is located in different positions in, or with respect to, enclosure 3. Figure 7a shows the electrostatic particle filter 5 in a first position, relatively central and towards the bottom part of enclosure 3, partly or fully below the level of the electrical and/or electronic equipment 4. Figure 7b shows the electrostatic particle filter 5 in a second position which is closer to a side of the enclosure 3. Figure 7c shows an embodiment in which the electrostatic particle filter 5 is in a second position and inside a container or chamber 14 which is connected to and in communication with enclosure 3. Fluid can flow through a passage 16 between the chamber 14 and the enclosure 3. The passage 16 may be part of a device arranged configured such that the chamber 14 may be disconnected from/connected to the enclosure 3 for filter exchange 36a or maintenance without water ingress and/or loss of pressure.

According to an example it may be also considered to power the electrostatic filter 5 in the enclosure 3 of an electronic and/or electrical module arrangement 1 with a medium voltage MV input fed from an AC power input. However, in this case, voltage control and rectifier circuits are also required, which makes this solution less attractive.

According to another embodiment, enclosure 3 may be constructed as a rigid, pressure-resistant, non-pressure compensated, 1-bar type of housing. In this case the enclosure 3 is constructed to withstand an outside pressure of around 300 bar whilst maintaining a pressure of around 1 bar inside enclosure 3.

According to an embodiment, an off-line electrostatic filtering concept for a frequency converter can also be considered. In this case, the electrostatic filter is positioned in a separate chamber (not shown in Figure 1, see 14 in Figure 7c). Such a separate chamber may be detachable from the main enclosure 3 for the purpose of exchanging or cleaning the electrostatic particle filter 5. In the case that the enclosure 1 is of a pressure compensated type, the detachable separate chamber may be a non-pressure compensated chamber. With the electrostatic particle filter arranged in a separate enclosure it may be preferred that a pump is used to control or supplement the flow of liquid past the filter, and the pump may be mounted in the main enclosure 3, or else in the separate chamber e.g. 14 together with the filter. In the latter case filter may also have its own power supply. The filter and/or pump can also be powered directly from the pressure-compensated type of enclosure 3 via penetrators. An important key feature of such an off-line embodiment is that the electrostatic filter has to be arranged such that it may be disconnected from/connected to the enclosure 3 for filter exchange 36a or maintenance without water ingress and/or loss of pressure.

The methods according to the second aspect of the invention of operating or controlling an electronic and/or electrical module arrangement 1 as described above in reference to Figures 2-4, and elsewhere in this specification may be carried out by a computer program or computer application comprising computer program elements or software code which, when loaded in a processor, controller, computer or local control and protection unit, causes the computer or processor to carry out the method steps. The functions operating or controlling an electrostatic particle filter 5 in an electronic and/or electrical module arrangement 1 may be carried out by processing digital functions, algorithms and/or computer programs and/or by analogue components or analogue circuits or by a combination of both digital and analogue functions. The functions may be implemented using computer hardware or configurable hardware such as a Field-Programmable Gate Array (FPGA) or other types of processors including a Complex Programmable Logic Device (CPLD) or an Application Specific Integrated Circuit (ASIC).

The computer programs are stored at least in part in computer readable memory and as such accessible by the one or more processors. The or each processor may be in a memory storage unit of a process system control unit or a local control and protection unit or a PLC (Programmable Logic Controller) or other system part thereof, or may as well run in a remote control system topside or onshore. A part of the computer programs may be stored in a processor as above, but also in a ROM, RAM, PROM, EPROM or EEPROM chip or similar memory means. The program in part or in whole may also be stored on, or in, other suitable computer readable medium such as a magnetic disk, such as a CD (compact disc) or a DVD (digital versatile disc), a Blu-Ray disc, hard disk, magneto-optical memory storage means, in volatile memory, in flash memory, as firmware, stored on a data server or on one or more arrays of data servers. Other known and suitable media, including removable memory media such as a USB memory stick or other removable flash memories, hard drives, flash drives etc. may also be used.

Figure 6 shows schematically a data carrier or computer readable medium such as a CD or DVD 60 on which the computer program 63 is stored. As noted above, the computer program product could also be embodied as a memory of a device, such as memory of a local (subsea) control and protection device; or of a control or protection device installed topside or onshore. While the computer program 63 is shown here schematically as a track on the depicted optical disk 60, the computer program can be stored in any way which is suitable for the computer program product.

It should be noted that while the above describes exemplifying embodiments of the invention, there are several variations and modifications which may be made to the disclosed solution without departing from the scope of the present invention as defined in the appended claims.

## Claims

1. An electronic and/or electrical module arrangement (1) for a subsea installation (18), said electronic and/or electrical module arrangement (1) comprising electronic and/or electrical equipment (4) which is arranged in an enclosure (3) and which electronic and/or electrical equipment (4) is immersed in a dielectric liquid (11), **characterised in that** an electrostatic particle filter (5) is arranged in contact with the dielectric liquid (11) inside the enclosure (3) and configured for removing contaminants from the dielectric liquid (11), and **in that** said electronic and/or electrical module arrangement (1) comprises means for supplying electrical power by a DC power supply to said electronic and/or electrical equipment (4) and to said electrostatic particle filter (5).

2. The electronic and/or electrical module arrangement (1) according to claim 1, **characterised in that** said electronic and/or electrical module arrangement (1) comprises at least one equipment from the group of: a variable frequency converter, a transformer, a switchgear, a bypass switch, an electrical distribution box or junction.

3. The electronic and/or electrical module arrangement (1) according to claim 1, **characterised in that** the electronic and/or electrical equipment (4) comprises one or more capacitors.

4. The electronic and/or electrical module arrangement (1) according to claim 1 or 2, **characterised in that** the dielectric liquid (11) is an insulating oil or liquid ester.

5. The electronic and/or electrical module arrangement (1) according to anyone of claims 1-4, **characterised in that** the electrostatic particle filter (5) in contact with the dielectric liquid (11) inside the enclosure (3) is arranged such that the dielectric liquid (11) is urged to flow past the electrostatic particle filter (5) by means of natural convection currents (8) caused by thermal losses in said electronic and/or electrical equipment (4).

6. The electronic and/or electrical module arrangement (1) according to anyone of claims 1-5, **characterised in that** the electrostatic particle filter (5) is arranged inside a container (14) connected to the enclosure (3).

7. The electronic and/or electrical module arrangement (1) according to anyone of claims 1-6, **characterised in that** a flow of the dielectric liquid (11) is urged in part by a pump or other actuator.

8. The electronic and/or electrical module arrangement (1) according to anyone of claims 4-7, **characterised in that** the enclosure (3), or a container (14) connected to it and in communication (16) with it, is arranged comprising one or more sensors.

9. The electronic and/or electrical module arrangement (1) according to anyone of claims 1-8, **characterised in that** said electronic and/or electrical module arrangement (1) in said subsea installation (18) is used to control and/or drive one or more subsea loads from any of the group of: a motor, an induction motor, a pump, a water injection pump, a compressor, a gas compressor, a multiphase pump motor, a separator pump motor.

10. A method for operating an electronic and/or electrical module arrangement (1) for a subsea installation (18), which said electronic and/or electrical module arrangement is powered by an AC or DC link power supply (17) and comprises electronic and/or electrical equipment (4) which is arranged in an enclosure (3) and which electronic and/or electrical equipment (4) is immersed in a dielectric liquid (11), wherein an electrostatic particle filter (5) is arranged in contact with the dielectric liquid (11) inside the enclosure (3) and configured for removing contaminants from the dielectric liquid (11), wherein the electrostatic particle filter (5) is supplied with electrical power by a DC power supply to said electronic and/or electrical equipment (4), wherein the method comprises the steps of:
switching on the AC or DC power supply and monitoring (32) said electronic and/or electrical equipment (4) with one or more sensors, and if a signal is detected (34) that a parameter related to a condition of the electrostatic particle filter (5) is measured or estimated to be greater than a predetermined threshold, then signalling (36) a requirement for exchange (36a), or cleaning (36b), of the electrostatic particle filter (5).

11. The method according to claim 10, **characterised by** signalling (36), on receipt of a signal (34) that a condition has exceeded a predetermined threshold, that a change in operating load or operating cycle is advised.

12. The method according to claim 10, **characterised by** carrying out a procedure for cleaning (36b) the electrostatic particle filter (5) using any method from the group of: applying one or more electrical pulses (52) of a selected polarity across the electrostatic particle filter (5); applying one or more mechanical vibrations (54) to the electrostatic particle filter (5); a combination (56) of mechanical and electrostatic methods.

13. The method according to claim 10, **characterised by** exchanging (36a, 38-40) a container (14) comprising the electrostatic particle filter (5) and replacing it (36a, 42-44) with a second container comprising a second electrostatic particle filter.

14. A computer program product for operating an electronic and/or electrical module arrangement (1) in a subsea installation (18), which said electronic and/or electrical module arrangement (1) comprises electronic and/or electrical equipment (4) which is arranged inside an enclosure (3) and which electronic and/or electrical equipment (4) is immersed in a dielectric liquid (11), **characterised in that** an electrostatic particle filter (5) is arranged in contact with the dielectric liquid (11) inside the enclosure (3) and configured for removing contaminants from the dielectric liquid (11) wherein the electrostatic particle filter (5) is supplied with electrical power by a DC power supply to said electronic and/or electrical equipment (4), wherein said computer program product is provided on a computer readable medium or data carrier (60) and comprises computer program (63) code configured to cause a processor or control unit connected to said electrical equipment to carry out the steps of:
switching on the AC or DC power supply and monitoring (30, 32) with one or more sensors said electronic and/or electrical equipment (4), and, if a signal is detected (34) that a variable related to a condition of an electrostatic particle filter (5) is measured or estimated to be greater than a predetermined threshold, then signalling a requirement (36) for exchange (36a), or cleaning (36b), of the electrostatic particle filter (5).

## Patentansprüche

1. Elektronische und/oder elektrische Modulanordnung (1) für eine Unterwasserinstallation (18), wobei die elektronische und/oder elektrische Modulanordnung (1) elektronische und/oder elektrische Ausrüstung (4) aufweist, die in einem Gehäuse (3) angeordnet ist, und wobei die elektronische und/oder elektrische Ausrüstung (4) in eine dielektrische Flüssigkeit (11) getaucht ist, **dadurch gekennzeichnet, dass** ein elektrostatisches Partikelfilter (5) in Kontakt mit der dielektrischen Flüssigkeit (11) in dem Gehäuse (3) angeordnet und ausgebildet ist, Verunreinigungen aus der dielektrischen Flüssigkeit (11) zu entfernen, und dass die elektronische und/oder elektrische Modulanordnung (1) Mittel zum Zuführen von elektrischer Leistung durch eine Gleichstromleistungsversorgung zu der elektronischen und/oder elektrischen Ausrüstung (4) und zu dem elektrostatischen Partikelfilter (5) aufweist.

2. Elektronische und/oder elektrische Modulanordnung (1) nach Anspruch 1, **dadurch gekennzeichnet, dass** die elektronische und/oder elektrische Modulanordnung (1) mindestens eine Ausrüstung aus der folgenden Gruppe aufweist: einen variablen Frequenzumformer, einen Transformator, eine Schaltvorrichtung, einen Überbrückungsschalter, einen elektrischen Verteilerkasten oder eine Verzweigung.

3. Elektronische und/oder elektrische Modulanordnung (1) nach Anspruch 1, **dadurch gekennzeichnet, dass** die elektronische und/oder elektrische Ausrüstung (4) einen oder mehrere Kondensatoren aufweist.

4. Elektronische und/oder elektrische Modulanordnung (1) nach Anspruch 1 oder 2, **dadurch gekennzeichnet, dass** die dielektrische Flüssigkeit (11) ein Isolieröl oder ein flüssiger Ester ist.

5. Elektronische und/oder elektrische Modulanordnung (1) nach einem der Ansprüche 1-4, **dadurch gekennzeichnet, dass** das elektrostatische Partikelfilter (5) in Kontakt mit der dielektrischen Flüssigkeit (11) in dem Gehäuse (3) derart angeordnet ist, dass die dielektrische Flüssigkeit (11) mittels durch Wärmeverluste in der elektronischen und/oder elektrischen Ausrüstung (4) verursachten Eigenkonvektionsströmen (8) getrieben wird, an dem elektrostatischen Partikelfilter (5) vorbeizufließen.

6. Elektronische und/oder elektrische Modulanordnung (1) nach einem der Ansprüche 1-5, **dadurch gekennzeichnet, dass** das elektrostatische Partikelfilter (5) in einem mit dem Gehäuse (3) verbundenen Behälter (14) angeordnet ist.

7. Elektronische und/oder elektrische Modulanordnung (1) nach einem der Ansprüche 1-6, **dadurch gekennzeichnet, dass** eine Strömung der dielektrischen Flüssigkeit (11) teilweise durch eine Pumpe oder einen anderen Aktuator angetrieben wird.

8. Elektronische und/oder elektrische Modulanordnung (1) nach einem der Ansprüche 4-7, **dadurch gekennzeichnet, dass** das Gehäuse (3) oder ein damit verbundener und damit in Verbindung (16) stehender Behälter (14) mit einem oder mehreren Sensoren ausgestaltet ist.

9. Elektronische und/oder elektrische Modulanordnung (1) nach einem der Ansprüche 1-8, **dadurch gekennzeichnet, dass** die elektronische und/oder elektrische Modulanordnung (1) in der Unterwasserinstallation (18) verwendet wird, um einen oder mehrere Unterwasserverbraucher aus einem beliebigen der folgenden Gruppe zu steuern und/oder anzutreiben: einen Motor, einen Induktionsmotor, eine Pumpe, eine Wassereinspritzpumpe, einen Verdichter, einen Gasverdichter, einen Mehrphasenpumpenmotor, einen Abscheiderpumpenmotor.

10. Verfahren zum Betreiben einer elektronischen und/oder elektrischen Modulanordnung (1) für eine Unterwasserinstallation (18), wobei die elektronische und/oder elektrische Modulanordnung durch eine Wechselstrom- oder Gleichstrom-Zwischenkreisleistungsversorgung (17) mit Leistung versorgt wird und elektronische und/oder elektrische Ausrüstung (4) aufweist, die in einem Gehäuse (3) angeordnet ist, und wobei die elektronische und/oder elektrische Ausrüstung (4) in eine dielektrische Flüssigkeit (11) getaucht ist, wobei ein elektrostatisches Partikelfilter (5) in Kontakt mit der dielektrischen Flüssigkeit (11) in dem Gehäuse (3) angeordnet und ausgebildet ist, Verunreinigungen aus der dielektrischen Flüssigkeit (11) zu entfernen, wobei das elektrostatische Partikelfilter (5) durch eine Gleichstromleistungsversorgung zu der elektronischen und/oder elektrischen Ausrüstung (4) mit elektrischer Leistung versorgt wird, wobei das Verfahren folgende Schritte umfasst:
Einschalten der Wechselstrom- oder Gleichstromleistungsversorgung und Überwachen (32) der elektronischen und/oder elektrischen Ausrüstung (4) mit einem oder mehreren Sensoren, und wenn ein Signal detektiert (34) wird, dass ein Parameter in Zusammenhang mit einem Zustand des elektrostatischen Partikelfilters (5) als größer als ein vorbestimmter Schwellenwert gemessen oder geschätzt wird, dann Anzeigen (36) eines Erfordernisses für einen Austausch (36a) oder ein Reinigen (36b) des elektrostatischen Partikelfilters (5) .

11. Verfahren nach Anspruch 10, **gekennzeichnet durch** Anzeigen (36), bei Empfang eines Signals (34), dass ein Zustand einen vorbestimmten Schwellenwert überschritten hat, dass eine Änderung einer Betriebslast oder eines Arbeitszyklus empfohlen wird.

12. Verfahren nach Anspruch 10, **gekennzeichnet durch** Durchführen eines Vorgangs eines Reinigens (36b) des elektrostatischen Partikelfilters (5) unter Verwendung eines beliebigen Verfahrens aus der folgenden Gruppe: Aufbringen eines oder mehrerer elektrischer Impulse (52) einer ausgewählten Polarität über das elektrostatische Partikelfilter (5); Aufbringen einer oder mehrerer mechanischer Schwingungen (54) auf das elektrostatische Partikelfilter (5); eine Kombination (56) von mechanischen und elektrostatischen Verfahren.

13. Verfahren nach Anspruch 10, **gekennzeichnet durch** Austauschen (36a, 38-40) eines Behälters (14) mit dem elektrostatischen Partikelfilter (5) und Ersetzen davon (36a, 42-44) durch einen zweiten Behälter mit einem zweiten elektrostatischen Partikelfilter.

14. Computerprogrammprodukt zum Betreiben einer elektronischen und/oder elektrischen Modulanordnung (1) für eine Unterwasserinstallation (18), wobei die elektronische und/oder elektrische Modulanordnung (1) elektronische und/oder elektrische Ausrüstung (4) aufweist, die in einem Gehäuse (3) angeordnet ist, und wobei die elektronische und/oder elektrische Ausrüstung (4) in eine dielektrische Flüssigkeit (11) getaucht ist, **dadurch gekennzeichnet, dass** ein elektrostatisches Partikelfilter (5) in Kontakt mit der dielektrischen Flüssigkeit (11) in dem Gehäuse (3) angeordnet und ausgebildet ist, Verunreinigungen aus der dielektrischen Flüssigkeit (11) zu entfernen, wobei das elektrostatische Partikelfilter (5) durch eine Gleichstromleistungsversorgung zu der elektronischen und/oder elektrischen Ausrüstung (4) mit elektrischer Leistung versorgt wird, wobei das Computerprogrammprodukt auf einem computerlesbaren Medium oder Datenträger (60) bereitgestellt ist und einen Computerprogramm(63)-Code umfasst, der ausgestaltet ist, einen Prozessor oder eine Steuereinheit, der/die mit der elektrischen Ausrüstung verbunden ist, zu veranlassen, die folgenden Schritte auszuführen:
Einschalten der Wechselstrom- oder Gleichstromleistungsversorgung und Überwachen (30, 32) der elektronischen und/oder elektrischen Ausrüstung (4) mit einem oder mehreren Sensoren, und, wenn ein Signal detektiert (34) wird, dass eine Variable in Zusammenhang mit einem Zustand eines elektrostatischen Partikelfilters (5) als größer als ein vorbestimmter Schwellenwert gemessen oder geschätzt wird, dann Anzeigen eines Erfordernisses (36) für einen Austausch (36a) oder ein Reinigen (36b) des elektrostatischen Partikelfilters (5) .

## Revendications

1. Agencement (1) de modules électroniques et/ou électriques destiné à une installation sous-marine (18), ledit agencement (1) de modules électroniques et/ou électriques comportant un équipement électronique et/ou électrique (4) qui est disposé dans une enceinte (3) et ledit équipement électronique et/ou électrique (4) étant immergé dans un liquide diélectrique (11), **caractérisé en ce qu'**un filtre électrostatique (5) à particules est disposé en contact avec le liquide diélectrique (11) à l'intérieur de l'enceinte (3) et configuré pour éliminer des contaminants du liquide diélectrique (11), et **en ce que** ledit agencement (1) de modules électroniques et/ou électriques comporte un moyen servant à faire fournir une énergie électrique par une alimentation à courant continu audit équipement électronique et/ou électrique (4) et audit filtre électrostatique (5) à particules.

2. Agencement (1) de modules électroniques et/ou électriques selon la revendication 1, **caractérisé en ce que** ledit agencement (1) de modules électroniques et/ou électriques comporte au moins un équipement issu du groupe formé de : un convertisseur à fréquence variable, un transformateur, un appareillage de commutation, un commutateur de dérivation, une boîte de distribution ou une jonction électrique.

3. Agencement (1) de modules électroniques et/ou électriques selon la revendication 1, **caractérisé en ce que** l'équipement électronique et/ou électrique (4) comporte un ou plusieurs condensateurs.

4. Agencement (1) de modules électroniques et/ou électriques selon la revendication 1 ou 2, **caractérisé en ce que** le liquide diélectrique (11) est une huile isolante ou un ester liquide.

5. Agencement (1) de modules électroniques et/ou électriques selon l'une quelconque des revendications 1 à 4, **caractérisé**
**en ce que** le filtre électrostatique (5) à particules en contact avec le liquide diélectrique (11) à l'intérieur de l'enceinte (3) est disposé de telle façon que le liquide diélectrique (11) est poussé à s'écouler le long du filtre électrostatique (5) à particules au moyen de courants (8) de convection naturelle causés par des pertes thermiques dans ledit équipement électronique et/ou électrique (4).

6. Agencement (1) de modules électroniques et/ou électriques selon l'une quelconque des revendications 1 à 5, **caractérisé**
**en ce que** le filtre électrostatique (5) à particules est disposé à l'intérieur d'un récipient (14) relié à l'enceinte (3).

7. Agencement (1) de modules électroniques et/ou électriques selon l'une quelconque des revendications 1 à 6, **caractérisé**
**en ce qu'**un écoulement du liquide diélectrique (11) est mû en partie par une pompe ou autre actionneur.

8. Agencement (1) de modules électroniques et/ou électriques selon l'une quelconque des revendications 4 à 7, **caractérisé**
**en ce que** l'enceinte (3), ou un récipient (14) relié à celle-ci et en communication (16) avec celle-ci, est disposé (e) de façon à comporter un ou plusieurs capteurs.

9. Agencement (1) de modules électroniques et/ou électriques selon l'une quelconque des revendications 1 à 8, **caractérisé**
**en ce que** ledit agencement (1) de modules électroniques et/ou électriques dans ladite installation sous-marine (18) est utilisé pour commander et/ou actionner une ou plusieurs charges sous-marines quelconques issues du groupe formé de : un moteur, un moteur asynchrone, une pompe, une pompe d'injection d'eau, un compresseur, un compresseur de gaz, un moteur de pompe multiphasique, un moteur de pompe de séparateur.

10. Procédé d'exploitation d'un agencement (1) de modules électroniques et/ou électriques destiné à une installation sous-marine (18), ledit agencement de modules électroniques et/ou électriques étant alimenté par une alimentation (17) à liaison en courant alternatif ou continu et comportant un équipement électronique et/ou électrique (4) qui est disposé dans une enceinte (3) et ledit équipement électronique et/ou électrique (4) étant immergé dans un liquide diélectrique (11), un filtre électrostatique (5) à particules étant disposé en contact avec le liquide diélectrique (11) à l'intérieur de l'enceinte (3) et configuré pour éliminer des contaminants du liquide diélectrique (11), le filtre électrostatique (5) à particules étant alimenté en énergie électrique par une alimentation à courant continu vers ledit équipement électronique et/ou électrique (4), le procédé comportant les étapes consistant à :
mettre sous tension l'alimentation à courant alternatif ou continu et surveiller (32) ledit équipement électronique et/ou électrique (4) à l'aide d'un ou de plusieurs capteurs, et si un signal est détecté (34) selon lequel un paramètre lié à un état du filtre électrostatique (5) à particules est mesuré ou estimé comme étant supérieur à un seuil prédéterminé, signaler (36) un besoin d'échange (36a), ou de nettoyage (36b), du filtre électrostatique (5) à particules.

11. Procédé selon la revendication 10, **caractérisé par** le fait de signaler (36), suite à la réception d'un signal (34) selon lequel un état a dépassé un seuil prédéterminé, qu'une modification de la charge d'exploitation ou du cycle d'exploitation est recommandée.

12. Procédé selon la revendication 10, **caractérisé par** la réalisation d'une procédure de nettoyage (36b) du filtre électrostatique (5) à particules en utilisant un procédé quelconque issu du groupe formé de :
l'application d'une ou de plusieurs impulsions électriques (52) d'une polarité choisie aux bornes du filtre électrostatique (5) à particules ;
l'application d'une ou de plusieurs vibrations mécaniques (54) au filtre électrostatique (5) à particules ;
une combinaison (56) de procédés mécaniques et électrostatiques.

13. Procédé selon la revendication 10, **caractérisé par** l'échange (36a, 38-40) d'un récipient (14) comportant le filtre électrostatique (5) à particules et son remplacement (36a, 42-44) par un deuxième récipient comportant un deuxième filtre électrostatique à particules.

14. Produit de programme informatique destiné à exploiter un agencement (1) de modules électroniques et/ou électriques dans une installation sous-marine (18), ledit agencement (1) de modules électroniques et/ou électriques comportant un équipement électronique et/ou électrique (4) qui est disposé à l'intérieur de une enceinte (3) et ledit équipement électronique et/ou électrique (4) étant immergé dans un liquide diélectrique (11), **caractérisé en ce qu'**un filtre électrostatique (5) à particules est disposé en contact avec le liquide diélectrique (11) à l'intérieur de l'enceinte (3) et configuré pour éliminer des contaminants du liquide diélectrique (11), le filtre électrostatique (5) à particules étant alimenté en énergie électrique par une alimentation à courant continu vers ledit équipement électronique et/ou électrique (4), ledit produit de programme informatique étant placé sur un support lisible par ordinateur ou un support (60) de données et comportant du code de programme informatique (63) configuré pour amener un processeur ou une unité de commande reliés audit équipement électrique à réaliser les étapes consistant à :
mettre sous tension l'alimentation à courant alternatif ou continu et surveiller (30, 32), à l'aide d'un ou de plusieurs capteurs, ledit équipement électronique et/ou électrique (4), et, si un signal est détecté (34) selon lequel une variable liée à un état d'un filtre électrostatique (5) à particules est mesuré ou estimé comme étant supérieur à un seuil prédéterminé, signaler un besoin (36) d'échange (36a), ou de nettoyage (36b), du filtre électrostatique (5) à particules.
